Europäisches Patentamt

European Patent Office

Office européen des brevets

(19)

(11) Publication number: **0 139 519**
**A2**

# EUROPEAN PATENT APPLICATION

(12)

(21) Application number: **84307074.9**

(22) Date of filing: **16.10.84**

(51) Int. Cl.⁴: **F 26 B 13/26**
**F 26 B 13/30, F 26 B 7/00**

(30) Priority: **19.10.83 GB 8327950**

(43) Date of publication of application:
**02.05.85 Bulletin 85/18**

(84) Designated Contracting States:
**AT BE CH DE FR GB IT LI LU NL SE**

(71) Applicant: **Robertsons Chemicals Limited**
**Bury Road**
**Wattisfield Diss Norfolk(GB)**

(72) Inventor: **Robertson, Alistair**
**Glentramman Manor House**
**Lezayre Nr. Ramsey Isle of Man(GB)**

(72) Inventor: **Baker, Cyril Percival**
**Mill House Norton**
**Nr. Bury St. Edmunds Suffolk(GB)**

(74) Representative: **Gillam, Francis Cyril et al,**
**Sanderson & Co. 97 High Street**
**Colchester Essex C01 1TH(GB)**

(54) **Drying apparatus.**

(57) Apparatus for removing liquid from laminae comprises a pair of rollers 10,11 together defining a nip through which the laminae 25 are to be passed. Each roller 10 and 11 comprises an inner tube 12 around which is journalled a perforate sleeve 13, there being a highly absorbent porous layer 14 of a textile material around the sleeve 13. Each inner tube 12 has a line of openings 16 facing those of the other tube, and a pump 21 is arranged to extract air from both inner tubes. Air drawn into the tubes entrains moisture carried by laminae passed through the nip, the air flow rate being highest in the region of the nip.

EP 0 139 519 A2

./...

Croydon Printing Company Ltd.

FIG.1

## DRYING APPARATUS

This invention relates to apparatus for removing liquid from at least one surface of substantially flat sheet-, strip-, or plate-like articles, referred to hereinafter collectively as "laminae". For example the apparatus finds particular - but not exclusive - use in the processing of a printed circuit board, following the etching thereof.

Many industrial processes use liquid chemicals to treat substantially rigid articles in plate, sheet or strip form. In general it is most desirable to recover any chemical remaining on the articles as they leave the treatment zone, so that the recovered chemicals may be re-cycled, thereby reducing the cost of processing. Also, in the case of noxious or other chemicals likely to cause pollution of the environment, it is most advantageous to remove as much chemical as possible in the immediate area of the treatment zone, so minimising the risk of pollution, or of injury to personnel. In a case where the articles are to be washed after treatment, the removal immediately after treatment of as much chemical as possible has the added advantage that contamination of the wash water by the chemical is much reduced. This may therefore reduce the volume of water required for effective washing, and also reduces the problems of disposing of large quantities of water containing dilute chemical agents.

There have been designed various apparati for at least removing surface liquid from laminae, or even for drying wet laminae, but most suffer from one disadvantage or another - for example, an apparatus may require a large energy input, so making it expensive to run, or the apparatus may be relatively large and

complex and so have a high initial and installation cost. Other disadvantages may be that the apparatus only imperfectly removes surface liquid from the material or that the apparatus requires frequent servicing to maintain its performance.

The manufacture of printed circuit boards is an example of an industrial process where it is most advantageous to remove a treatment liquid from an etched sheet. The usual process is for a track pattern to be etched into a copper-clad board, usually made of a synthetic resin loaded with glass fibres, the etching of the copper being performed with ferric chloride or some other etching fluid. On leaving the etching tank, the board must be cleaned of excess etchant and any iron adhering thereto, before the the board is dried for further processing steps. In view of the chemicals employed and the reaction taking place in the etching bath, it is important to ensure that as much etchant as is reasonably possible is removed before board is subjected to a washing process, in order to avoid carry-through of the etching chemicals into the washing bath. This then minimises the problems of disposing of the wash water. Moreover, by recovering the etchant from the removal stage, the processing cost may considerably be removed.

A very simple apparatus for removing excess water from laminae comprises a pair of flexible blades arranged to wipe the lamina surface, but the removal rate is very small. Better results can be obtained with a pair of rolls defining a nip through which the lamina is passed, but this still can leave a significant moisture film on the lamina. Much more extensive measures must be taken if that film is to be removed, such as multi-stage washing processes continuously diluting the moisture film, each stage using as little water as possible with a removal step between each stage.

It is a principal aim of this invention to provide apparatus for removing surface liquid from a lamina, in such a way that the removed liquid may be collected for safe disposal or re-use.

Accordingly, this invention provides apparatus for removing surface liquid from at least one surface of a lamina, which apparatus comprises a pair of rollers mounted with their axes substantially parallel to define a nip therebetween and through which the lamina may be passed, at least one of the rollers having an absorbent outer layer, characterised in that the absorbent outer layer is carried on a sleeve rotatably mounted on an inner tube, the cylindrical surface of the sleeve being perforate and the tube having one or more openings extending parallel to the axis thereof in a line, the openings being directed generally towards the other roller, and in that evacuation means arranged to draw air axially out of the inner tube so inducing inwardly-directed air flow through the absorbent outer layer and sleeve.

With the apparatus of this invention, tests have shown that extremely good moisture removal can be achieved, leaving virtually no treatment solution on a wet lamina entering the nip between the rolls. This then obviates the need to use large quantities of wash water, and the recovered treatment solution is in an undiluted state.

Most preferably, the pair of rollers defining the nip are of essentially the same construction, such that each roller has an absorbent outer layer carried on a sleeve which is rotatably mounted on an inner tube. The cylindrical surfaces of the two sleeves should be perforated substantially all over, and the two tubes each should have a line of openings extending parallel to the tube axis and which are directed generally towards the other roller. Then, by arranging for the evacuation means to draw air axially out of both inner tubes, inwardly directed air flows will be induced in the region of the nip, through both of the absorbent outer layers of the two rollers respectively, so removing excess surface liquid from both plane surfaces of a lamina fed through the nip defined by the pair of rollers. Though the apparatus of this invention could have but one roller having an absorbent outer layer, to remove liquid from only one surface of a piece of sheet material, all references in the following will be to apparatus having two similar rollers, as just described above.

The absorbent outer layer of each roller should have a relatively smooth outer surface, to prevent very small spots of liquid remaining on the lamina at points where the outer layer fails to touch the lamina. The outer layer should have a high liquid-holding capacity, and most preferably comprises a textile material, advantageously of considerable bulk. For example, the absorbent layer may be formed by so-called towelling or by a velvet-like fabric, wrapped around the sleeve. To increase the absorbency of such a layer, the material preferably is wound around the sleeve several times, so forming a relatively thick absorbent layer. Another possibility for the absorbent layer would be to provide a cylinder of an open-celled foamed material, fitted on to the sleeve such that air may be drawn inwardly through the foamed material and into the sleeve, through the perforations therein.

Optimum results are obtained with a relatively large inwardly-directed air flow into the rollers, and this is best achieved with a high-volume pump operating at a relatively small depression, rather than under conditions of high vacuum, and the absorbent outer layer should be selected to permit such operation. A typical volume flow rate would be in the range of 5 to 8½ litres/min of air per 100 mm length of tube.

The internal diameter of the sleeve should be such that the sleeve is freely rotatable on the inner tube, and an outer diameter suitable for providing a roller of the required overall diameter. The sleeve could instead have a relatively thin wall, and be rotatably mounted on the tube by way of appropriately dimensioned bushes or bearings, but in such a case it may be necessary to modify the tube design to ensure the inwardly-directed air flow through the absorbent outer layer of the roller takes place in the region of the nip. Conveniently, the sleeve is made of a metal, such as titanium or stainless steel or of a plastics material, such as polyvinylchloride - but account should be taken of the nature of the liquid with which the apparatus is to be used when selecting a material for the sleeve.

Each perforation in the sleeve may be of circular shape - formed for example by radial bores extending through the sleeve wall. The perforations should be formed over substantially the whole of the cylindrical surface, and the "free air ratio" of the sleeve is preferably about 50% - that is to say, the total area of the perforations in the sleeve constitutes about 50% of the total area of the cylindrical surface of the sleeve.

The inner tube is arranged rotatably to support the sleeve and to permit air to enter the bore of the tube through one or more openings formed in a line extending parallel to the tube axis. Thus, a single, elongate slot-like opening could be provided, or a plurality of shorter aligned slots. Another possibility is to have a line of holes, each for example of circular shape. By providing the opening(s) in a single line, on the side of the tube facing the other roller, the resultant inwardly-directed air flow into the roller will tend to be in the region of the nip itself, so

assisting removal of liquid from a lamina fed through the nip.

To permit the extraction of air from the tube bore, one end of the inner tube may be blanked off, the other end being provided with a nozzle permitting the attachment of a vacuum pipe thereto. The tube also should appropriately be configured to permit the supporting of the tube in a frame of the overall apparatus. Also, the apparatus may include power drive means for at least one of the two sleeves, so automatically to draw through the nip a lamina offered thereto: alternatively, the lamina could simply be pushed through the nip whilst air is drawn out of the two tubes of the two rollers.

The apparatus includes evacuation means to draw air out of the or each roller tube, so generating the inwardly-directed air flow in the region of the nip, and advantageously there is a separator unit for liquid associated with the evacuation means, arranged to separate liquid entrained in the air flow drawn from the inner tube(s). Such an evacuation means and the separator unit may be conventional in design. Another possibility is for the evacuation means to comprise a Venturi-type pump, installed for example in a pumped liquid flow line for the liquid to be removed from the laminae. This permits very simple installation, and avoids the need to use a separator and vacuum pump, which could become contaminated by the removed liquid.

By way of example only, one specific embodiment of apparatus of this invention and arranged particularly for the removal of surface liquid from printed circuit boards during the manufacture thereof but suitable for use with a flat plate- or sheet-like objects in general whenever wetted during the processing thereof, will now be described in detail, reference being made to the accompanying drawings, in which:-

Figure 1 is a diagrammatic perspective view of the embodiment of the apparatus; and

Figure 2 is a cross-sectional view through one of the rollers shown in Figure 1.

The apparatus of this invention comprises a pair of rollers 10 and 11, suitably supported in a frame (not shown) with their axes parallel and with their outer peripheries pressed lightly into engagement with one another, thereby to define a nip. Each roller comprises an inner tube 12, a sleeve 13 rotatable about the tube 12, and an absorbent outer layer 14. The tube 12 is held against rotation, and the sleeve 13 has an inner diameter which is a free rotatable fit upon the tube 12.

The sleeve 13 of each roller is perforated over substantially all of its cylindrical surface, each perforation 15 being in the form of a circular hole extending radially of the sleeve. The total area of all the perforations 15 is substantially equal to 50% of the total external cylindrical surface area of the sleeve 13, with the perforations being aligned in axial rows and in radial planes. The tube 12 of each roller has a single line of circular holes 16, the line extending parallel to the axis of the tube. The tube is mounted so that each hole 16 is directed towards the other tube of the pair thereof.

The outer layer 14 on each roller comprises several turns of a porous and absorbent towelling material - made for example of cotton or a synthetic fibre/cotton mix. The outer layer could instead comprise a velvet-like fabric, such as a so-called synthetic chamois fabric, similarly wound round the rollers.

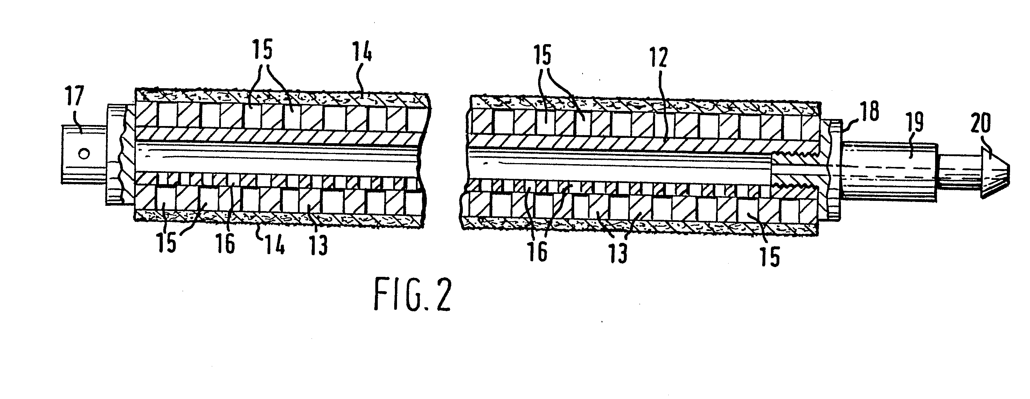

As shown in Figure 2, one end of the tube 12 is let into a boss 17 adapted for mounting in the apparatus frame, whereas the other end of the tube has a bush 18 threaded thereinto. The bush 18 defines a cylindrical surface 19 to permit the mounting thereof in the apparatus frame, and the free end of the bush is formed as a nipple 20, permitting the connection thereto of a flexible vacuum hose (not shown).

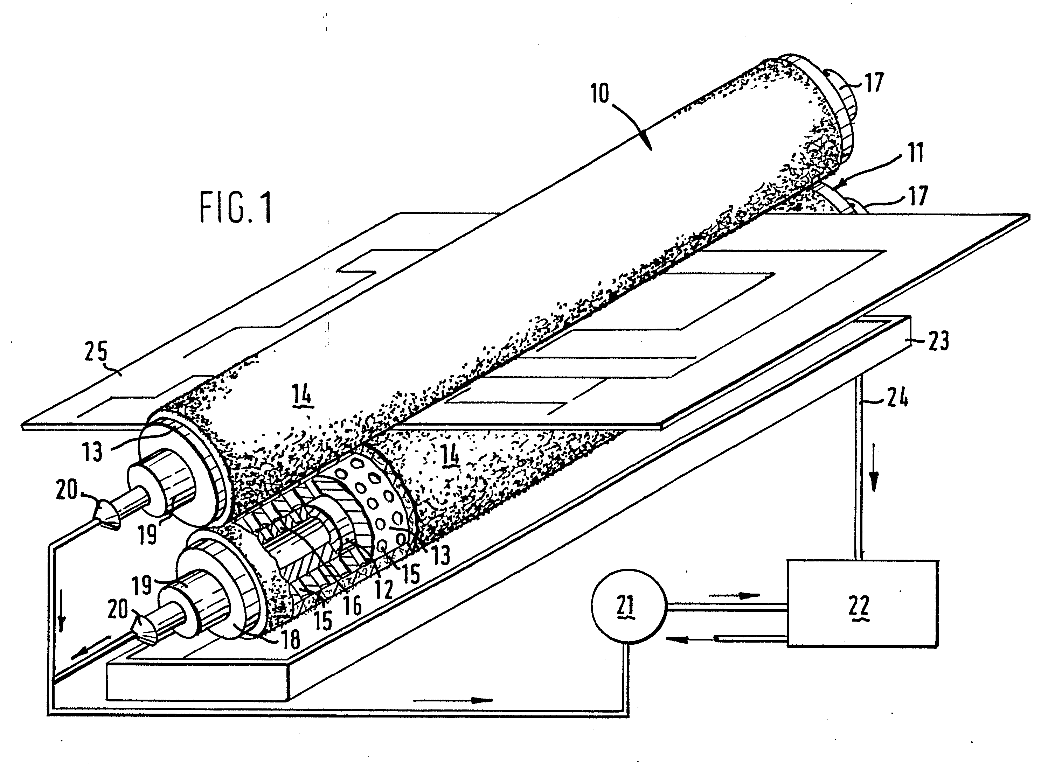

As shown diagrammatically in Figure 1, the apparatus also comprises a pump 21, arranged to draw air out of the two tubes 12 and a tank 22 for collecting liquid entrained in the air flow from the pump 21 for subsequent re-use, or disposal as appropriate. Alternatively, the liquid may simply be redirected to the process tank for re-use there. The tank may suitably be configured to assist the separation of the liquid from the air flow, before the air is discharged to atmosphere. Also provided is a drip tray 23, disposed beneath the two rollers 10 and 11 and having a drainpipe 24 leading to the tank 22.

In operation, the pump 21 draws air from the interior of the two tubes 12 of the two rollers 10 and 11 respectively, so producing inwardly-directed air flows through the absorbent outer layers 14 of the two rollers. In view of the particular configuration of the rollers, the inward air flow is mostly in the region of the nip defined by the two rollers. An etched printed circuit board 25 having surface liquid thereon is pushed through the nip, as illustrated in Figure 1, so turning the rollers as the board is advanced. The absorbent outer layers 14 of the rollers serve to absorb liquid from the surface of the board, but this removal action is greatly assisted by the inwardly-directed air flow through the rollers, in the region of the nip. This air flow entrains the absorbed liquid, to remove it from the absorbent outer layers and carry it to the tank 22, where the liquid is collected.

In a specific arrangement of apparatus as described above, using a velvet-like synthetic chamois fabric on the two rolls, it was found that very high liquid removal rates could be achieved with inwardly directed air volume flow rates of the order of 20 to 50 litres/min, for each tube. In this case each tube was approximately 600 mm long and about 25 mm overall diameter, and these flow rates were obtained with a depression of about 200 mB below atmosphere, with the fabric outer layers dry. On those layers becoming wet, the depression rose to about 300 mB below atmosphere, but flow rates in the above range were maintained.

Tests with Venturi-type pumps also gave good results with air-flows in the above range, the pumps being installed in a pumped liquid flow path for the liquid being removed from the laminae. In this case, the removed liquid mixes immediately with the pumped liquid, and after appropriate filtering or possibly other processing, that liquid may be returned to the treatment bath. This much simplifies the liquid recovery process and also obviates the need to provide a separate vacuum pump and separator, as well as the possibility of contamination of the vacuum pump by removed liquid.

The apparatus has been illustrated in a horizontal configuration. For some processes, and particularly the gold plating of electrical and electronic connectors as printed circuit boards and the like where particularly valuable processing solutions are used, it may be advantageous to use a vertical configuration, with the boards or the like moving vertically upwardly out of the treatment bath and immediately into the nip of the apparatus, defined by rollers 10 and 11.

As mentioned above, the apparatus of this invention is suitable for use in the processing of flat sheet-, plate-, or strip-like products, whenever the same are wetted with a liquid. The described apparatus may need modification for use with certain products or process liquids, for example in size and/or proportions, or in the materials from which the component parts are made.

CLAIMS

1.  Apparatus for removing surface liquid from at least one surface of a lamina, comprising a pair of rollers mounted with their axes substantially parallel to define a nip therebetween and through which the lamina may be passed, at least one of the rollers having an absorbent outer layer, characterised in that the absorbent outer layer (14) is carried on a sleeve (13) rotatably mounted on an inner tube (12) the cylindrical surface of the sleeve being perforate and the tube (12) having one or more openings (16) in a line extending parallel to the axis of the tube (12), the openings (16) being directed generally towards the other roller (10 or 11), and in that evacuation means (21) are arranged to draw air axially out of the inner tube (12) so inducing inwardly-directed air flow through the absorbent outer layer (14) and the sleeve (13).

2.  Apparatus according to claim 1, characterised in that each roller (10 or 11) of the pair thereof defining the nip is of essentially the same construction as the other roller of the pair.

3.  Apparatus according to claim 1 or claim 2, characterised in that absorbent outer layer (14) of each roller comprises a textile material wrapped around the sleeve (13).

4.  Apparatus according to claim 3, characterised in that the textile material forming the outer layer (14) is a towelling fabric or a velvet-like fabric.

5.  Apparatus according to any of the preceding claims, characterised in that the internal diameter of the sleeve (13) is such that the sleeve is freely rotatable on the inner tube.

6.  Apparatus according to any of the preceding claims, characterised in that the sleeve (13) has perforations (15) over substantially the whole area thereof, to give a free air ratio of about 50%.

7. Apparatus according to any of the preceding claims, characterised in that the inner tube (12) has a plurality of circular openings (16) arranged in a row running parallel to the tube axis, the openings all lying in the same plane as contains the axes of the two rollers (10,11).

8. Apparatus according to any of the preceding claims, characterised in that one end of each inner tube (12) is sealed, and the other end of each tube (12) is provided with a nozzle (20) permitting the attachment of a vacuum pipe thereto, and characterised in that the two ends of each inner tube are configured to permit the supporting thereof in a frame of the overall apparatus, there being power drive means for at least one of the two sleeves (13) to effect the rotation thereof.

9. Apparatus according to any of the preceding claims, characterised in that the evacuation means (21) is arranged to draw air through the outer layer (14) of each roller at a rate in the range of 5 to 8½ litre/min per linear 100 mm of roller length.

10. Apparatus according to claim 9, further characterised in that the evacuation means (21) comprises a Venturi-type pump installed in a pumped liquid flow line for the liquid to be removed from a lamina passing through the nip defined by the rollers (10,11).

FIG.1

0139519

FIG.2

0139519